# EUROPEAN PATENT APPLICATION

(11) **EP 4 300 571 A1**
(43) Date of publication of application: **03.01.2024**
(21) Application number: 22181245.6
(22) Date of filing: 27.06.2022
(51) Int. Cl.: H01L 23/373, H01L 23/42, H01L 21/48

(54) **POWER SEMICONDUCTOR MODULE ARRANGEMENT AND METHOD FOR FORMING THE SAME**

(71) Applicant: Infineon Technologies Austria AG, 9500 Villach (AT)
(72) Inventor: BOHNENBERGER, Timo, 93073 Neutraubling (DE); HEINRICH, Alexander, 93077 Bad Abbach (DE); WILLE, Catharina, 93049 Regensburg (DE)
(74) Representative: Westphal, Mussgnug & Partner, Patentanwälte mbB

(57) **Abstract**

A power semiconductor module arrangement comprises a power semiconductor module (100), wherein the power semiconductor module (100) comprises a substrate (10), and a heat-conducting layer (40) arranged on a lower surface of the power semiconductor module (100), wherein the lower surface of the power semiconductor module (100) is a surface that is configured to be mounted to a heat sink (30), wherein the heat-conducting layer (40) consists of a metallic foam (402) and an eutectic material (404) filling the cavities within the metallic foam (402).

## Description

### TECHNICAL FIELD

The instant disclosure relates to a power semiconductor module arrangement and to a method for forming the same, in particular to a power semiconductor module arrangement comprising a thermal interface material.

### BACKGROUND

Power semiconductor modules usually include at least one substrate. The substrate may be arranged on a base plate. A semiconductor arrangement including a plurality of semiconductor components (e.g., two diodes, MOSFETs, JFETs, HEMTs, IGBTs, or any other suitable controllable semiconductor elements in a parallel, half-bridge, or any other configuration) is usually arranged on at least one of the at least one substrates. Each substrate usually comprises a substrate layer (e.g., a ceramic layer), a first metallization layer deposited on a first side of the substrate layer and a second metallization layer deposited on a second side of the substrate layer. The controllable semiconductor components are mounted, for example, on the first metallization layer. The first metallization layer may be a structured layer while the second metallization layer is usually a continuous layer. The second metallization layer may be attached to a base plate.

Heat that is generated by the controllable semiconductor components is dissipated through the substrate and further through an (optional) base plate to a heat sink. A heat-conducting layer is usually arranged between the substrate and the heat sink (in base plate-less modules) or between a base plate and the heat sink (in modules comprising a base plate) to effectively conduct the heat away from the substrate. The heat-conducting layer is required to have adequate heat conducting properties (e.g., high thermal conductivity). At the same time, the heat-conducting layer is required to permanently mount the power semiconductor module to the heat sink (e.g., to form a firm substance-to-substance bond between the power semiconductor module and the heat sink).

There is a need for an improved power semiconductor module which provides for an improved thermal conductivity between the power semiconductor module and a heat sink, and for a method for forming the same.

### SUMMARY

A power semiconductor module arrangement includes a power semiconductor module, wherein the power semiconductor module includes a substrate, and a heat-conducting layer arranged on a lower surface of the power semiconductor module, wherein the lower surface of the power semiconductor module is a surface that is configured to be mounted to a heat sink, wherein the heat-conducting layer consists of a metallic foam and an eutectic material filling the cavities within the metallic foam.

A method for producing a power semiconductor module arrangement includes forming a heat-conducting layer on a lower surface of a power semiconductor module, wherein the power semiconductor module includes a substrate, the lower surface of the power semiconductor module is a surface that is configured to be mounted to a heat sink, and the heat-conducting layer consists of a metallic foam and an eutectic material filling the cavities within the metallic foam.

The invention may be better understood with reference to the following drawings and the description. The components in the figures are not necessarily to scale, emphasis is instead being placed upon illustrating the principles of the invention. Moreover, in the figures, like reference numerals designate corresponding parts throughout the different views.

### BRIEF DESCRIPTION OF THE DRAWINGS

Figure 1 schematically illustrates a cross-sectional view of a power semiconductor module according to one example.
Figure 2 schematically illustrates a cross-sectional view of a power semiconductor module according to another example.
Figure 3 schematically illustrates a cross-sectional view of a heat-conducting layer according to one example.
Figure 4 schematically illustrates a method step of forming a thermal interface layer on a power semiconductor module.
Figure 5 schematically illustrates an exemplary semiconductor module with a thermal interface layer and a protective foil.
Figure 6 schematically illustrates a method step of arranging a power semiconductor module with a thermal interface layer formed thereon on a heat sink.
Figure 7 schematically illustrates different examples of metallic foams.
Figures 8 to 10 schematically illustrate a method for forming a heat-conducting layer.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or be included in a semiconductor chip. A semiconductor body has electrically connecting pads and includes at least one semiconductor element with electrodes.

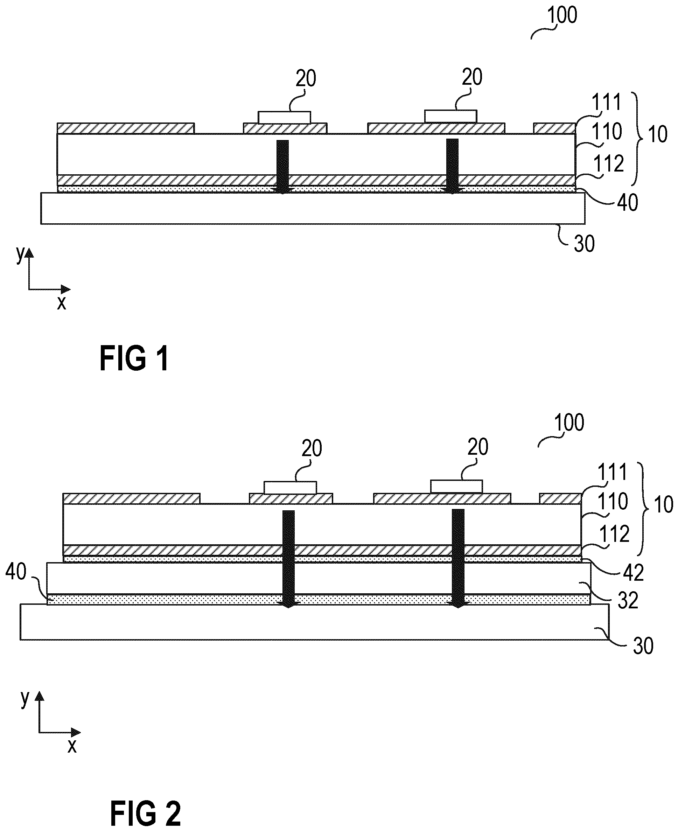

Figure 1 exemplarily illustrates a power semiconductor module 100 comprising a substrate 10. The substrate 10 includes a dielectric insulation layer 110, a (structured) first metallization layer 111 attached to the dielectric insulation layer 110, and a second metallization layer 112 attached to the dielectric insulation layer 110. The dielectric insulation layer 110 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. Optionally, the first and/or second metallization layer 111, 112 may be covered by a thin layer of nickel or silver, for example. Such a layer may be formed using a nickel plating process or a silver plating process, for example. The substrate 10 may be a ceramic substrate, that is, a substrate in which the dielectric insulation layer 110 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 110 may consist of or include one of the following materials: Al₂O₃, AlN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate.

Usually one or more semiconductor bodies 20 are arranged on a substrate 10. Each of the semiconductor bodies 20 arranged on a substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element. One or more semiconductor bodies 20 may form a semiconductor arrangement on the substrate 10. In Figure 1, two semiconductor bodies 20 are exemplarily illustrated. Any other number of semiconductor bodies 20, however, is also possible.

In the example illustrated in Figure 1, the power semiconductor module 100 only comprises the substrate 10 with the semiconductor bodies 20 mounted thereon. Usually, the power semiconductor module 100 further comprises additional components such as, e.g., electrical connections and a housing or an encapsulant. Such additional components, however, are of no specific relevance for the present invention and, therefore, are omitted in the figures for the sake of clarity. The power semiconductor module 100 (the substrate 10 in the example of Figure 1) is attached to a heat sink 30 with the second metallization layer 112 of the substrate 10 arranged between the dielectric insulation layer 110 and the heat sink 30. A heat-conducting layer 40 (thermal interface material TIM) is arranged between the second metallization layer 112 and the heat sink 30 and is configured to form a firm substance-to-substance bond between the substrate 10 and the heat sink 30. Heat that is generated by the semiconductor bodies 20 may be dissipated through the substrate 10 and the heat-conducting layer 40 to the heat sink 30. This is exemplarily illustrated by the bold arrows in Figure 1.

The second metallization layer 112 of the semiconductor substrate 10 in Figure 1 is a continuous layer. The first metallization layer 111 is a structured layer in the arrangement illustrated in Figure 1. "Structured layer" in this context means that the first metallization layer 111 is not a continuous layer, but includes recesses between different sections of the layer. Such recesses are schematically illustrated in Figure 1. The first metallization layer 111 in this arrangement exemplarily includes four different sections. Different semiconductor bodies 20 may be mounted to the same or to different sections of the first metallization layer 111. Different sections of the first metallization layer 111 may have no electrical connection or may be electrically connected to one or more other sections using electrical connections such as, e.g., bonding wires. Electrical connections may also include connection plates or conductor rails, for example, to name just a few examples. The first metallization layer 111 being a structured layer, however, is only an example. It is also possible that the first metallization layer 111 is a continuous layer. According to another example, the substrate 10 may only comprise a dielectric insulation layer 110 and a first metallization layer 111. The second metallization layer 112 may be omitted. In this case, the heat-conducting layer 40 may be arranged between the dielectric insulation layer 110 and the heat sink 30, for example.

In the example illustrated in Figure 1, the substrate 10 itself forms a bottom of the power semiconductor module 100. The substrate 10 may be arranged in a housing or may be molded in a casing (not specifically illustrated in Figure 1) and may form a bottom of the housing or casing. That is, a lower surface of the power semiconductor module 100 that is in direct contact with the heat-conducting layer 40 may be provided by the substrate 10. According to another example, the substrate 10 is arranged on an additional base plate 32. This is schematically illustrated in Figure 2. In an arrangement comprising a base plate 32, the base plate 32 may form a bottom of a housing or casing. The substrate 10 may be arranged within a cavity formed by the housing, for example, or may be enclosed by the casing. In some examples, only one substrate 10 is arranged on a base plate 32. In other examples, more than one substrate 10 may be arranged on a single base plate 32. In an arrangement comprising a base plate 32, the lower surface of the power semiconductor module 100 is provided by the base plate 32, and the heat-conducting layer 40 (thermal interface material TIM) is arranged between the base plate 32 and the heat sink 30 and is configured to form a firm substance-to-substance bond between the base plate 32 and the heat sink 30. Heat that is generated by the semiconductor bodies 20 may be dissipated through the substrate 10, the base plate 32, and the heat-conducting layer 40 to the heat sink 30. This is exemplarily illustrated by the bold arrows in Figure 2.

According to an even further example which is not specifically illustrated, the power semiconductor module 100 comprises a housing, the housing comprising sidewalls, a lid and a bottom or ground plate. One or more substrates 10 may be arranged in the housing. Optionally, the one or more substrates 10 may be arranged on a base plate 32, the base plate 32 also being arranged inside the housing. The lower surface of the power semiconductor module 100 in this case may be provided by the ground plate of the housing. The lower surface of the power semiconductor module 100 may be provided by any other suitable component of the power semiconductor module 100.

An additional heat-conducting layer 42 consisting of the same material as the heat-conducting layer 40 may be arranged between the substrate 10 and the base plate 32, for example. This additional heat-conducting layer 42, however, is optional. The substrate 10 may be mounted to the base plate 32 by means of any other suitable kind of connection layer (e.g., by means of a conventional solder or sinter layer).

The base plate 32 may comprise a metal, for example. According to one example, the base plate comprises at least one of Al and Cu. According to another example, the base plate 32 may be a metal matrix composite (MMC) base plate comprising an MMC material such as AlSiC. Any other suitable materials are possible. The base plate 32, optionally, may also be covered by a thin layer of nickel or silver, for example. Such a layer may be formed using a nickel plating process or a silver plating process, for example.

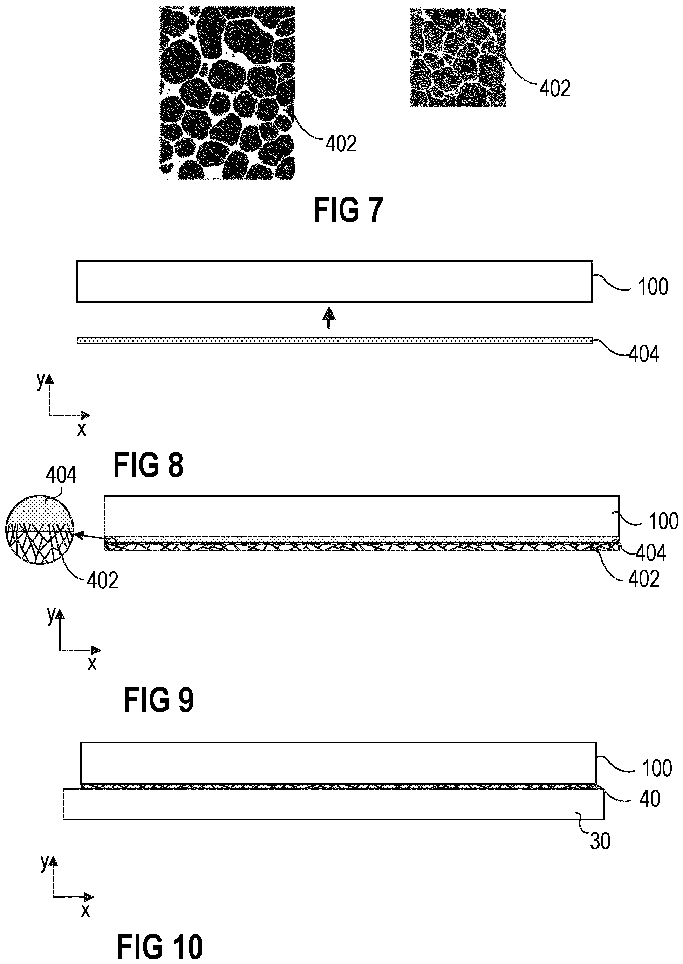

The heat-conducting layer 40 comprises a metal foam 402 and a eutectic material 404. A metal foam is a cellular structure consisting of a solid material with gas filled pores, the gas filled pores constituting a large portion of the volume (e.g., at least 70%, at least 80%, or even at least 90%). The pores may be interconnected for example (open-cell foam). According to one example, only 5 - 25 % of the overall volume of the metal foam 402 is formed by the base metal. That is, the base metal of the metallic foam 402 forms a framework or capillary, open fibre-structure that may be filled by a second material. Exemplary metallic foams are schematically illustrated in Figure 7. The metallic foam 402 may be compressible to a certain degree. According to one example, the second material filling the framework or capillary, open fibre-structure of the metallic foam 402 is a eutectic material 404. The eutectic material 404 is solid at temperatures of below a certain threshold temperature, and is fluid at temperatures of above the threshold temperature. The threshold temperature may be between 60 and 90°C, for example.

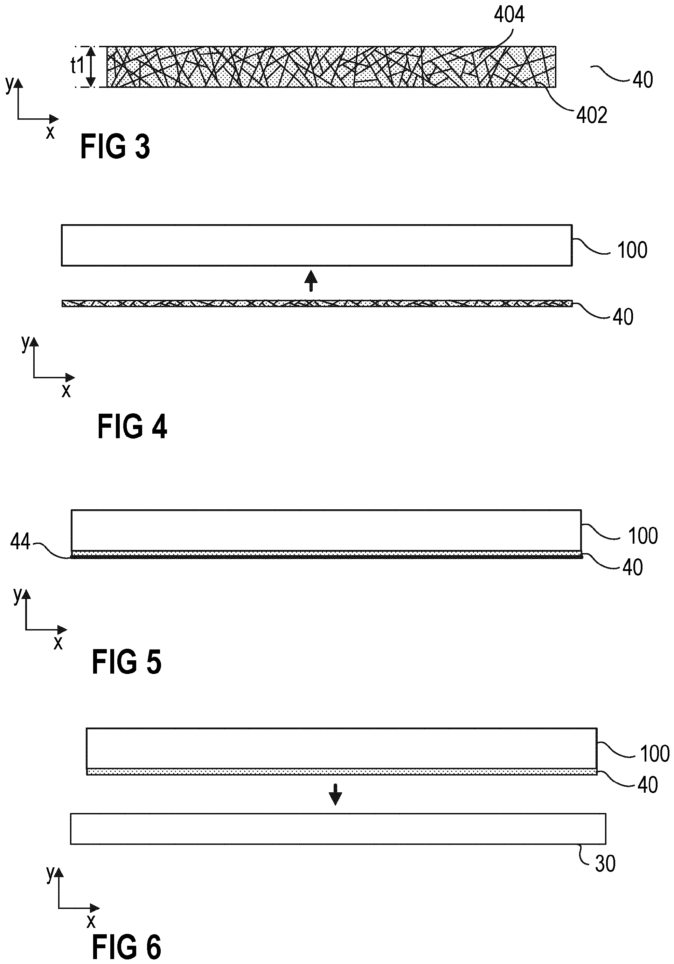

According to one example, the metallic foam 402 is formed first. Methods for forming metallic foams are generally known and will not be described in further detail herein. When the eutectic material 404 is in its liquid state, the metallic foam 402 may easily soak it in and contain the eutectic material 404 such that the eutectic material 404 fills the cavities or pores within the metallic foam 402, resulting in the heat-conducting layer 40. This is exemplarily illustrated in Figure 3. The heat-conducting layer 40 may have a thickness t1 of between 50µm and 500µm, for example. This thickness t1 of the heat-conducting layer 40 may be defined by the thickness of the metallic foam 402.

The metallic foam 402 may consist of or may comprise aluminum, copper, steel, nickel, silver, gold, platinum, or palladium, for example. The eutectic material 404 may comprise at least one of indium, bismuth, tin, zinc, germanium, silver, antimony, or gallium, for example. According to one example, the eutectic material 404 consists of indium, bismuth and tin. For example, the eutectic material 404 may comprise 51 weight% of indium, 32.5 weight% of bismuth, and 16.5 weight% of tin. A material with this specific composition is viscous in a temperature range that corresponds to a typical temperature range (e.g., 70°C - 100°C) during operation of the power semiconductor module 100. Other examples of suitable eutectic materials 404 for operating temperature ranges between 60°C and 175°C include pure indium, or an indium-tin alloy with 52 weight% of indium and 48 weight% of tin.

If even higher temperatures occur during operation of the power semiconductor module 100 (e.g., temperatures of 200°C or even more), other compositions may be more suitable such as, e.g., a tin-zinc alloy with 13 weight% of tin and 87 weight% of zinc, a tin-zinc-bismuth-germanium alloy with 83.5 to 84 weight% of tin, 12.5 to 13 weight% of zinc, 2.5 to 3 weight% of bismuth and less than1 weight% of germanium, a tin-bismuth-antimony-silver alloy with 59 weight% of tin, 38 weight% of bismuth, 0.7 weight% of antimony, and 2 weight% of silver, a tin-bismuth alloy with 42 weight% of tin and 58 weight% of bismuth, a tin-silver alloy with 96.5 weight% of tin and 3.5 weight% of silver, a tin-silver, antimony alloy with 65 weight% of tin, 25 weight% of silver and 10 weight% of antimony, or an indium-tin-antimony alloy with 17 weight% of indium, 66 weight% of tin and 17 weight% of antimony. Similar weight% ratios as those mentioned above are generally also possible. Other eutectic materials 404 which become liquid at temperatures typically occurring in power semiconductor modules 100 are also possible.

According to one example, the eutectic material 404 comprises or consists of: indium;
indium and tin;
bismuth, indium and tin;
tin and zinc;
tin, zinc, bismuth and germanium;
tin, bismuth, antimony and silver;
tin and bismuth;
tin and silver;
tin, silver and antimony; or
indium, tin and antimony,
wherein the listed materials and combinations of materials form a predominant part of the eutectic material 404, e.g., at least 80 weight%, at least 90 weight%, or at least 95 weight%.

The metallic foam 402 may be completely soaked with the eutectic material 404. That is, the eutectic material 404 may fill at least 95% of the cavities and hollow spaces within the metallic foam 402.

A heat-conducting layer 40 comprising a metallic foam 402 filled with a eutectic material 404 is a very flexible layer that provides good gap-filling properties at temperatures occurring during the operation of the power semiconductor module 100. In particular, the metallic components comprised in the eutectic material bond to the metallic surfaces (e.g., copper or nickel surfaces) of the power semiconductor module 100 and the heat sink 30, but do not form any alloys with the neighboring metallic surfaces. The eutectic material 404, when in its fluid state, fills any roughness or unevenness of the neighboring metallic surfaces (e.g., lower surface of power semiconductor module 100 or heat sink 30). That is, a thermal contact between the heat-conducting layer 40 and its neighboring components is excellent during operation of the power semiconductor module 100. The metallic foam 402 prevents the eutectic material from losing its shape when in its fluid state. That is, a pump-out of the eutectic material 404 does not occur even at higher temperatures. The main heat-conducting capability of the heat-conducting layer 40 is provided by the eutectic material 404, while the metallic foam's 402 main function is to contain the eutectic material 404 and prevent the eutectic material 404 from pumping out. The metal comprised in the metallic foam, therefore, may have a melting temperature that is significantly higher than the melting temperature of the eutectic material 404 and that is also significantly higher than the typical operating temperatures such that the metallic foam keeps its form during operation of the power semiconductor module 100. The heat-conducting layer 40 as described herein reduces or even dissolves any thermal bottlenecks of conventional power semiconductor modules 100.

The eutectic material 404 of the heat-conducting layer 40 being solid at temperatures below the threshold temperature (below the typical operating temperatures) allows to easily handle the power semiconductor module 100 with the heat-conducting layer 40 attached thereto, e.g., during shipping.

The heat-conducting layer 40 may be formed on or attached to the lower surface of the power semiconductor module 100 by means of different alternative processes. Figure 4 very generally illustrates a method step of forming a heat-conducting layer 40 on or applying/attaching a heat-conducting layer 40 to a lower surface of a power semiconductor module 100. As mentioned above, the heat-conducting layer 40 may have a thickness of 50µm to 500µm in a vertical direction y, wherein the vertical direction y is a direction that is perpendicular to the lower surface of the power semiconductor module 100.

According to one example, the power semiconductor module 100 may be completely assembled before the heat-conducting layer 40 is formed thereon /attached thereto. That is, all steps that are performed during the assembly of the power semiconductor module 100 which may require applying heat to the power semiconductor module 100 may be performed while the heat-conducting layer 40 has not yet been formed thereon /attached thereto. As has been described above, the power semiconductor module 100 may be a power semiconductor module 100 comprising a base plate 32, or may be a base plate-less power semiconductor module 100.

According to one example, the heat-conducting layer 40 may be produced separately as a foil or plate. Such a foil or plate may be easily handled at temperatures below the first threshold temperature (e.g., at room temperature). According to one example, a layer of eutectic material 404 may be formed and a metallic foam 402 may then be pressed on the layer of eutectic material 404. The layer of eutectic material 404 may be heated such that it becomes liquid and the metallic foam 402 may easily penetrate into the layer of eutectic material 404. The resulting heat-conducting layer 40 may subsequently be cooled down again such that the eutectic material 404 becomes solid again and the heat-conducting layer 40 may be easily handled. The pre-produced foil or plate may be then be applied to the lower surface of the power semiconductor module 100. For example, the foil or plate may be tacked, hot rolled, or laminated on the lower surface of the power semiconductor module 100. According to one example, temperature may be applied to the heat-conducting layer 40 during the process of attaching it to the lower surface of the power semiconductor module 100. For example, the temperature applied may just be high enough for the eutectic material 404 contained in the heat-conducting layer 40 to become slightly liquid. When the temperature is reduced again, the eutectic material 404 becomes solid again and permanently attaches to the lower surface of the power semiconductor module 100. Optionally, a certain amount of pressure may also be applied when attaching the heat-conducting layer 40 (i.e., the pre-produced foil or plate) to the lower surface of the power semiconductor module 100.

Optionally, the heat-conducting layer 40 may be protected by a protecting foil 44 after applying the heat-conducting layer 40 to / forming the heat-conducting layer on the power semiconductor module 100. In this way, the heat-conducting layer 40 is well protected during shipping of the power semiconductor module 100 and before mounting the power semiconductor module 100 to a heat sink 30. A protective foil 44 may protect the heat-conducting layer 40 from any kind of environmental influences such as, e.g., dust, foreign particles, or oxygen. A heat-conducting layer 40 that is protected by a protective foil 44 is schematically illustrated in Figure 5.

If a protective foil 44 is applied to the heat-conducting layer 40, this protective foil 44 may be removed again before mounting the power semiconductor module 100 to a heat sink 30. The power semiconductor module 100 may be mounted to the heat sink 30 with the heat-conducting layer 40 arranged between the power semiconductor module 100 and the heat sink 30. The power semiconductor module 100 may be pressed onto the heat sink 30. According to one example, heat may be applied during the step of mounting the power semiconductor module 100 to the heat sink 30. In this way, the heat-conducting layer 40, i.e. the eutectic material 404 comprised in the heat-conducting layer 40, may become viscous. When the arrangement is subsequently cooled down again, the heat-conducting layer 40 attaches the power semiconductor module 40 to the heat sink 30. The step of mounting the power semiconductor module 40 to the heat sink 30 is exemplarily illustrated in Figure 6.

During subsequent operation of the power semiconductor module 100, heat may be generated (e.g., by the semiconductor bodies 20) which is conducted away through the heat-conducting layer 40 to the heat sink 30. The heat-conducting layer 40 is heated to temperatures of above the threshold temperature. The eutectic material 404, therefore, becomes liquid during operation of the power semiconductor module 100. In the liquid state of the eutectic material 404, the heat-conducting layer 40 still forms a firm substance-to-substance bond between the power semiconductor module 100 and the heat sink 30. The material of the heat-conducting layer 40, i.e. the eutectic material 404, does not leak out from under the power semiconductor module 100 due to the metallic foam 402 preventing the leak-out and the heat-conducting layer 40 remains essentially in its desired shape.

According to another example, it is also possible to form the heat-conducting layer 40 directly on the lower surface of the power semiconductor module 100, e.g., by applying the eutectic material 404 by means of a pattern-dispensing process or by means of stencil printing. Other suitable processes can also be used to form a layer of the eutectic material 404. This is schematically illustrated in Figure 8. The metallic foam 402 may then be pressed on the layer of eutectic material 404, without liquefying the eutectic material 404 (see cross-sectional view, right, and magnified detail, left, in Figure 9). Even in the solid state of the eutectic material 404, the metallic foam 402 may partly (but not entirely) penetrate into the layer of eutectic material 404. The metallic foam 402 then adheres to (is partly pressed into) the layer of eutectic material 404. The adhesion generally is strong enough in order to keep the metallic foam 402 in its position during shipping. However, the layer of eutectic material 404 and the metallic foam 402 at this point still generally represent two separate layers. The power semiconductor module 100 may then be arranged on a heat sink 30, as is schematically illustrated in Figure 10. When the eutectic material 404 is heated during first operation of the power semiconductor module 100, the eutectic material 404 soaks into the metallic foam 402 and remains there during the lifetime of the power semiconductor module 100. That is, the formation of the heat-conducting layer 40 is completed during the first operation of the power semiconductor module 100.

The lower surface of the power semiconductor module 100 may be prepared before applying the heat-conducting layer 40 / the eutectic material 404. The surface of the heat sink 30 to which the power semiconductor module 100 is mounted may be prepared in a similar way. In particular, every surface that comes into direct contact with the heat-conducting layer 40 may be prepared correspondingly. A main aspect of surface preparation may be to ensure the wettability of the concerned surfaces. A thin oxide layer may form on a metal surface when it comes into contact with oxygen. For a sufficient wettability of a metal surface, for example, such an oxide layer may be removed before forming the heat-conducting layer 40 thereon. The oxide layer may be removed by means of a plasma reduction process, for example. Alternatively, it is also possible, for example, to plate the respective surface with a thin layer of a noble metal, or to use a preform (e.g., a pre-produced foil or plate) that is coated with a flux layer. This flux layer may comprise or consist of a reducing agent, for example, which activates the respective metallic surface when it comes into contact with the metallic surface. "Activating" in this context means that an oxide layer that has formed on the surface is reduced to pure metal. According to another example, the respective surface may be plated with a diffusion layer consisting of Ni (nickel), Ni-Ti (nickel-titanium), or any other suitable metal.

## Claims

1. A power semiconductor module arrangement comprising a power semiconductor module (100), wherein the power semiconductor module (100) comprises:
a substrate (10); and
a heat-conducting layer (40) arranged on a lower surface of the power semiconductor module (100), wherein the lower surface of the power semiconductor module (100) is a surface that is configured to be mounted to a heat sink (30), wherein
the heat-conducting layer (40) consists of a metallic foam (402) and an eutectic material (404) filling the cavities within the metallic foam (402).

2. The power semiconductor module arrangement of claim 1, wherein the lower surface of the power semiconductor module (100) is formed by a surface of the substrate (10).

3. The power semiconductor module arrangement of claim 1, wherein the power semiconductor module (100) further comprises a base plate (32), wherein the substrate (10) is arranged on a first surface of the base plate (32) and the lower surface of the power semiconductor module (100) is formed by a second surface of the base plate (32) opposite the first surface.

4. The power semiconductor module arrangement of any of the preceding claims, further comprising a heat sink (30), wherein the heat-conducting layer (40) is arranged between the power semiconductor module (100) and the heat sink (30), and permanently attaches the heat sink (30) to the power semiconductor module (100).

5. The power semiconductor module arrangement of any of the preceding claims, wherein the eutectic material (404) is solid at temperatures of below a threshold temperature, and is fluid at temperatures of above the threshold temperature, wherein the threshold temperature is between 60 and 90°C.

6. The power semiconductor module arrangement of any of the preceding claims, wherein the metallic foam (402) consist of or comprises aluminum, copper, steel, nickel, silver, gold, platinum, or palladium.

7. The power semiconductor module arrangement of any of the preceding claims, wherein the metallic foam (402) is compressible.

8. The power semiconductor module arrangement of claim 7, wherein the eutectic material (404) comprises or consists of
indium;
indium and tin;
bismuth, indium and tin;
tin and zinc;
tin, zinc, bismuth and germanium;
tin, bismuth, antimony and silver;
tin and bismuth;
tin and silver;
tin, silver and antimony; or
indium, tin and antimony.

9. The power semiconductor module arrangement of any of claims 1 to 8, wherein a thickness (t1) of the heat-conducting layer (40) in a vertical direction (y) that is perpendicular to the lower surface of the power semiconductor module (100) is between 50µm and 500µm.

10. The power semiconductor module arrangement of claim 9, wherein the thickness (t1) of the heat-conducting layer (40) is defined by the thickness of the metallic foam (402).

11. Method for producing a power semiconductor module arrangement, the method comprising:
forming a heat-conducting layer (40) on a lower surface of a power semiconductor module (100), wherein
the power semiconductor module (100) comprises a substrate (10);
the lower surface of the power semiconductor module (100) is a surface that is configured to be mounted to a heat sink (30); and
the heat-conducting layer (40) consists of a metallic foam (402) and an eutectic material (404) filling the cavities within the metallic foam (402).

12. The method of claim 11, wherein the step of forming a heat-conducting layer (40) on a lower surface of a power semiconductor module (100) comprises:
forming a layer of the eutectic material (404) on the lower surface of the power semiconductor module (100); and
pressing the metallic foam (402) on the layer of eutectic material (404) while the eutectic material (404) is in its solid state.

13. The method of claim 12, wherein the step of forming a heat-conducting layer (40) on a lower surface of a power semiconductor module (100) further comprises:
arranging the power semiconductor module (100) with the layer of eutectic material (404) formed thereon, and the metallic foam (402) pressed on the layer of eutectic material (402) on a heat sink (30); and
operating the power semiconductor module (100), wherein, during operation of the power semiconductor module (100), the eutectic material (404) liquefies due to the heat generated during operation of the power semiconductor module (100), and the metallic foam (402) soaks into the eutectic material (404).

14. The method of claim 1, wherein the step of forming a heat-conducting layer (40) on a lower surface of a power semiconductor module (100) comprises:
forming the heat-conducting layer (40) as a foil or plate and attaching the foil or plate to the lower surface of the power semiconductor module (100).

15. The method of claim 14, wherein the step of attaching the foil or plate to the lower surface of the power semiconductor module (100) comprises tacking, hot rolling, or laminating the foil or plate on the lower surface of the power semiconductor module (100).

## Amended claims

### Amended claims in accordance with Rule 137(2) EPC.

1. Method for producing a power semiconductor module arrangement, the method comprising:
forming a heat-conducting layer (40) on a lower surface of a power semiconductor module (100), wherein
the power semiconductor module (100) comprises a substrate (10);
the lower surface of the power semiconductor module (100) is a surface that is configured to be mounted to a heat sink (30); and
the heat-conducting layer (40) consists of a metallic foam (402) and an eutectic material (404) filling the cavities within the metallic foam (402),
the step of forming a heat-conducting layer (40) on a lower surface of a power semiconductor module (100) comprises
either forming a layer of the eutectic material (404) on the lower surface of the power semiconductor module (100), and pressing the metallic foam (402) on the layer of eutectic material (404) while the eutectic material (404) is in its solid state, or
forming the heat-conducting layer (40) as a foil or plate and attaching the foil or plate to the lower surface of the power semiconductor module (100), wherein forming the foil or plate comprises forming a layer of eutectic material (404), and pressing a metallic foam (402) on the layer of eutectic material (404) while the eutectic material (404) is in its solid state.

2. The method of claim 1, wherein the step of forming a heat-conducting layer (40) on a lower surface of a power semiconductor module (100) further comprises:
arranging the power semiconductor module (100) with the layer of eutectic material (404) formed thereon, and the metallic foam (402) pressed on the layer of eutectic material (402) on a heat sink (30); and
operating the power semiconductor module (100), wherein, during operation of the power semiconductor module (100), the eutectic material (404) liquefies due to the heat generated during operation of the power semiconductor module (100), and the metallic foam (402) soaks into the eutectic material (404).

3. The method of claim 1, wherein the step of attaching the foil or plate to the lower surface of the power semiconductor module (100) comprises tacking, hot rolling, or laminating the foil or plate on the lower surface of the power semiconductor module (100).
